# EUROPÄISCHE PATENTSCHRIFT

(11) **EP 0 681 221 B1**
(45) Veröffentlichungstag und Bekanntmachung des Hinweises auf die Patenterteilung: **26.01.2000**
(21) Anmeldenummer: 95106599.4
(22) Anmeldetag: 02.05.1995
(51) Int. Cl.: G03F 7/34, G03F 7/032, G03F 7/095

(54) **Lichtempfindliches Material und Verfahren zur Herstellung von Flachdruckplatten**
Light-sensitive material and process for preparation of planographic printing plates
Matériau photosensible et procédé pour faire des plaques d'impression

(30) Priorität: 04.05.1994 DE 4415607
(43) Veröffentlichungstag der Anmeldung: 08.11.1995
(73) Patentinhaber: Agfa-Gevaert AG, 51373 Leverkusen (DE)
(72) Erfinder: Gries, Willi-Kurt, Dr., D-65183 Wiesbaden (DE)

(56) Entgegenhaltungen:
- EP-A- 0 486 793
- EP-A- 0 487 260
- EP-A- 0 530 674
- EP-A- 0 650 094
- WO-A-93/05446
- US-A- 4 349 620

## Beschreibung

Die Erfindung betrifft ein lichtempfindliches Material, das für die Herstellung von Flachdruckplatten geeignet ist und als wesentliche Bestandteile
a) einen für Flachdruckplatten geeigneten Schichtträger,
b) eine hydrophile Schicht aus einem organischen Polymeren und einer radikalisch polymerisierbaren Verbindung,
c) eine photopolymerisierbare Schicht und
d) eine transparente Deckfolie
enthält.

Sie betrifft ferner ein Verfahren zur Herstellung von Flachdruckplatten, bei dem ein Material der vorstehend angegebenen Gattung bildmäßig belichtet und durch mechanisches Abziehen ("peel-apart"-Technik) der transparenten Deckfolie zusammen mit den unbelichteten Bereichen der Schicht (c) von dem Schichtträger (a) entwickelt wird. Materialien und Verfahren dieser Art haben den wesentlichen Vorteil, daß sie zu ihrer Verarbeitung keine Entwicklerlösungen erfordern, die umweltneutral entsorgt werden müssen. Bei der Belichtung ändert sich die Haftung der photopolymerisierbaren Schicht gegenüber den an sie angrenzenden Schichten, so daß beim Auseinanderziehen von Deckfolie und Schichtträger die belichteten Schichtbereiche an der einen Seite und die unbelichteten an der anderen Seite haften.

In der DE-C 15 72 122 ist ein Verfahren zur Herstellung von Bildern beschrieben, bei dem ein Material aus einer transparenten Folie, einer photopolymerisierbaren Schicht und einer zweiten Folie bildmäßig belichtet und durch Auseinanderziehen der Folie zu einem Negativ- und einem Positivbild entwickelt wird.

In der EP-A 514 186 und der US-A 4 895 787 sind ähnliche photopolymerisierbare, durch peel-apart-Entwicklung zu verarbeitende Materialien beschrieben, die zur Herstellung von Farbprüffolien dienen.

In den genannten Druckschriften werden Materialien beschrieben, bei denen eine farblose oder farbige photopolymerisierbare Schicht zwischen zwei dem jeweiligen Verwendungszweck angepaßten Folien angeordnet ist. Zwischen lichtempfindlicher Schicht und Träger- oder Deckfolien können nach Bedarf Haft-, Trenn- oder Farbschichten vorgesehen sein. In jedem Fall wird durch die Belichtung eine Änderung der Haftung gegenüber der Träger- oder Deckfolie bzw. der dazwischenliegenden Schicht und der Kohäsion innerhalb der lichtempfindlichen Schicht bewirkt, so daß durch Ausnutzung der Haftungs- bzw. Kohäsionsdifferenzen beim Auseinanderziehen der Folien eine bildmäßige Trennung innerhalb der lichtempfindlichen Schicht erfolgt. Eine saubere Trennung der belichteten bzw. unbelichteten Schichtbereiche von der jeweils weniger haftenden Folie wird dadurch ermöglicht, daß die Folien relativ glatte Oberflächen haben.

Problematischer ist die Herstellung von Flachdruckplatten nach diesem Verfahren, da die Nichtbildstellen von der Oberfläche des Druckplattenträgers abgelöst werden müssen, der gewöhnlich eine aufgerauhte und ggf. anodisierte Aluminiumplatte ist. Hier würden schon geringste Reste der oleophilen lichtempfindlichen Schicht, die in der rauhen porösen Trägeroberfläche zurückbleiben, die Verwendbarkeit stören, da sie zum Tonen in den Nichtbildstellen führen. Der Ersatz des Trägers durch ein Material mit glatter Oberfläche ist nicht ohne weiteres möglich, da für die Wasserführung beim Flachdruck die strukturierte hydrophile Oberfläche des Trägers erforderlich ist.

In der DE-A 27 25 762 werden lichtempfindliche Druckplatten beschrieben, die durch peel-apart-Entwicklung verarbeitet werden. Die Materialien weisen zwischen dem Druckplattenträger und der lichtempfindlichen photopolymerisierbaren Schicht eine hydrophile Zwischenschicht auf, die z. B. aus einem wasserlöslichen Silikat besteht. Hierdurch wird eine Verbesserung der Schichttrennung bei der Entwicklung erreicht, also eine gute Differenzierung zwischen oleophilen und hydrophilen Bereichen auf der Oberfläche der Druckplatte. Die starke Hydrophilie der Zwischenschicht macht diese aber angreifbar durch wäßrige Lösungen, so daß im Verlauf des Druckvorgangs die Bildelemente der oleophilen Bildschicht unterwaschen und angegriffen werden oder sich sogar ganz vom Träger lösen können. Es lassen sich deshalb keine befriedigenden Druckauflagen erreichen.

In der EP-A 530 674 wird ein ähnliches Material beschrieben, das zwischen dem Druckplattenträger und der photopolymerisierbaren Bildschicht eine Zwischenschicht aus einem hydrophilen Polymeren, z. B. Polyvinylalkohol, und einer polymerisierbaren Verbindung enthält. Bei der Belichtung nimmt die polymerisierbare Verbindung an der Polymerisation der photopolymerisierbaren Schicht teil und sorgt für eine erhöhte Haftung zwischen diesen Schichten. Wenn die Zwischenschicht nur aus Polymerem und polymerisierbarer Verbindung besteht, polymerisiert diese Verbindung im wesentlichen nur an der Grenzfläche zur photopolymerisierbaren Schicht. Da die Zwischenschicht eine Dicke von bevorzugt 5 bis 30 µm hat, bleibt der größte Teil dieser Schicht unpolymerisiert und damit wasserlöslich. Sie wird deshalb in den Bereichen der kleineren Rasterpunkte beim Druck durch das Feuchtwasser stark angegriffen und kann keine hohen Druckauflagen ergeben. Es ist zwar möglich, daß die Zwischenschicht thermisch oder photochemisch gehärtet wird; in diesem Fall besteht aber die Gefahr, daß die Schicht in den Nichtbildstellen oleophil wird, insbesondere wenn im Verlauf des Drucks das wasserlösliche Polymere aus der gehärteten Schicht ausgewaschen wird. Das führt zum Tonen und zur Minderung der Druckauflage.

In der WO-A 93/5446 wird ein Material beschrieben, das dem vorstehend beschriebenen ähnlich ist, aber eine hydrophile photopolymerisierbare Zwischenschicht mit einem relativ hohen Anteil an Monomeren und an Photoinitiator enthält. Hier unterliegt wiederum die Zwischenschicht der Gefahr einer ungewollten teilweisen Polymerisation, wenn sie bei der Verarbeitung nach der Bildbelichtung am Tageslicht gehandhabt wird. Hierbei kann ohne besondere Vorsichtsmaßnahmen leicht eine Polymerisation und damit Oleophilierung in den Nichtbildstellen eintreten, die zum Tonen führt. Diese Schicht wird deshalb vor dem Drucken bevorzugt mit Wasser oder Feuchtwasser ausgewaschen.

Aufgabe der Erfindung war es, ein negativ arbeitendes lichtempfindliches Material für die Herstellung von Flachdruckplatten vorzuschlagen, das sich ohne Anwendung von flüssigen Entwicklern zu einer Flachdruckplatte mit hoher Druckleistung und geringer Neigung zum Tonen verarbeiten läßt und das außer Bildbelichtung und peel-apart-Entwicklung keine weiteren Verarbeitungsschritte erfordert.

Die Erfindung geht aus von einem lichtempfindlichen Material für die Herstellung von Flachdruckplatten, das als wesentliche Bestandteile
a) einen Schichtträger,
b) eine hydrophile Schicht, die ein organisches Polymeres und eine radikalisch polymerisierbare Verbindung enthält,
c) eine photopolymerisierbare Schicht, die
   (1) ein polymeres Bindemittel,
   (2) eine radikalisch polymerisierbare Verbindung und
   (3) eine Verbindung oder eine Verbindungskombination enthält, die unter Einwirkung von aktinischer Strahlung die Polymerisation der Verbindung (2) einzuleiten vermag, und
d) eine transparente Deckfolie
enthält, wobei die Haftung der photopolymerisierbaren Schicht (c) an der hydrophilen Schicht (b) und/oder der Deckfolie (d) durch Belichten verändert wird.

Das erfindungsgemäße Material ist dadurch gekennzeichnet, daß der Schichtträger (a) aus Aluminium bzw. einer Aluminiumlegierung besteht und für den Flachdruck geeignet ist und daß die hydrophile Schicht (b) ein Schichtgewicht im Bereich von 0,001 bis 1 g/m² hat und keinen Photoinitiator umfaßt.

Das den Hauptbestandteil der hydrophilen Schicht (b) bildende organische hydrophile Polymere ist gewöhnlich wasserlöslich. Geeignete Polymere sind von C.L. McCormick, J.Bock und D.N.Schulz in Encyclopedia of Polymer Science and Engineering 17, 730 (1985) beschrieben. Allgemein sind natürliche und synthetische hydrophile Polymere, wie Nucleotide, Polypeptide, Polysaccharide, Poly(meth)acrylamide, Poly(meth)acrylsäuren, Polyethylenoxide, Polyvinylalkohole, Polyvinylpyrrolidone, deren Copolymere oder durch Pfropfen oder polymeranaloge Umsetzungen erhaltene wasserlösliche Derivate dieser oder ähnlicher Polymerer, z. B. Celluloseether, geeignet. Auch ionisierbare Stoffe wie Polyamine, Polyimine, Polyvinylpyrridine, Polysulfon- oder Polyphosphonsäuren können eingesetzt werden. Weiterhin sind auch amphotere Polymere, z. B. die in den DE-A 40 23 269 und 40 23 268 beschriebenen Acrylatcopolymeren, geeignet.

Als weiteren wesentlichen Bestandteil enthält die Schicht eine radikalisch polymerisierbare Verbindung in kleinerer Menge. Diese Verbindung enthält eine oder bevorzugt zwei oder mehrere polymerisierbare ethylenische Doppelbindungen. Geeignet sind vor allem hydrophile Ester oder Amide von (Meth)acryl-, Malein-, Fumar- oder Vinylphosphonsäure. Besonders Ester der Acryl- oder Methacrylsäure mit mehrwertigen aliphatischen Alkoholen, z. B. Glykolen, Oligoglykolen, Glycerin, Diglycerin, Trimethylolethan, Trimethylol-propan, Pentaerythrit, Dipentaerythrit, die vorzugsweise nur teilweise verestert und ggf. durch Umsetzen mit Ethylen- oder Propylenglykol verlängert sind, können mit Vorteil eingesetzt werden. Ebenso sind Amide der genannten ungesättigten Säuren sowie entsprechende Derivate von mehrfunktionellen Verbindungen wie Aminoalkoholen, Hydroxycarbonsäure und dgl. geeignet.

Der Mengenanteil an Polymeren liegt bevorzugt zwischen 50 und 95, bevorzugt zwischen 55 und 80, der an polymerisierbarer Verbindung zwischen 5 und 50, bevorzugt zwischen 20-45 Gew.-%. Die Schicht (b) kann ferner Farbstoffe, Tenside, Verlaufmittel, Trennmittel, Wachse, Pigmente, UV-Absorber und andere übliche Zusätze enthalten.

Das Schichtgewicht der hydrophilen Schicht (b) beträgt vorzugsweise 0,01 bis 1, besonders bevorzugt 0,05 bis 0,7 g/m². Das bedeutet, daß die Stärke der Schicht (b) höchstens 1 µm beträgt.

Die photopolymerisierbare Schicht (c) besteht aus einem oleophilen Gemisch, das ein polymeres Bindemittel (1), eine radikalisch polymerisierbare Verbindung (2) und einen durch Strahlung, insbesondere Licht, aktivierbaren Polymerisationsinitiator (3) enthält.

Das Bindemittel (1) muß mit den übrigen Bestandteilen kompatibel sein, d. h., über den gesamten Temperaturbereich von Herstellung und Anwendung darf keine Phasentrennung innerhalb der Schicht auftreten. Weiterhin ist es erforderlich, daß die unbelichteten Schichtstellen eine größere Haftung zur Deckfolie (d) als zum Schichträger (a) aufweisen. Umgekehrt sollten die belichteten Bereiche stärker am Schichtträger (a) als an der Deckfolie (d) haften, wobei innerhalb der Schicht eine möglichst glatte und scharfe Trennung der belichteten von den unbelichteten Schichtbereichen erfolgen sollte. Eine hohe Affinität zur Druckfarbe sowie chemische und mechanische Stabilität innerhalb des Druckprozesses werden ebenfalls durch das Bindemittel mitbestimmt. Beispiele geeigneter Polymerer sind chlorierte Polyolefine, z. B. chlorierte Polyethylene, chlorierte Polypropylene; Poly(meth)acrylsäureester, Polyacrylnitril, Polystyrol, Polyvinylchlorid, Polyvinylidenchlorid, Polybutadien, Polyisopren, Polychloropren, chlorierte Naturkautschuke, Polyvinylacetate, Polyvinylacetale, Polyester, Polyamide und Polyurethane sowie die Copolymeren der diesen Polymeren zugrundeliegenden Monomeren. Bevorzugt verwendet werden chlorierte Naturkautschuke, Poly(meth)acrylate und deren Copolymere sowie Polyamide. Ebenfalls bevorzugt eingesetzt werden Vertreter aus der Klasse der Polyvinylacetale, besonderes der Polyvinylbutyrale. Der Bindemittelanteil in der Photopolymerschicht bewegt sich zwischen 10 und 90, besser jedoch zwischen 70 und 30 %, jeweils bezogen auf das Gewicht der nichtflüchtigen Bestandteile.

Bei der radikalisch polymerisierbaren Verbindung (2) handelt es sich um eine ethylenisch ungesättigte Substanz oder ein entsprechendes Substanzgemisch in Form von Estern bzw. Amiden der Acryl-, Methacryl-, Fumar- oder Malein-säure. Bevorzugt sind Vertreter mit mehr als einer polymerisierbaren Doppelbindung, z.B. die Ester der genannten Säuren mit Alkandiolen, (Poly/Oligo)-ethylenglykolen, (Poly/Oligo)propylenglykolen, (Poly/Oligo)butylenglykolen und anderen bifunktionellen nieder- oder hochmolekularen organischen Diolen. Besonders geeignet sind die Ester von mehrwertigen Alkoholen, wie Glycerin, Trimethylolethan bzw. -propan, Pentaerythrit, Isocyanursäure, deren ethoxylierten oder propoxylierten Derivaten, sowie Dimere oder Oligomere dieser Verbindungen. Ein möglichst hoher Veresterungsgrad ist dabei vorteilhaft. Ebenfalls verwendbar sind Amide, z. B. die Verbindungen, die formal bei der Umsetzung von Ethylendiamin oder dessen Oligomeren mit den beschriebenen Säuren entstehen. Der Mengenanteil der Monomeren liegt bei etwa 5 bis 80, bevorzugt bei etwa 10 bis 60 Gew.-% der nichtflüchtigen Bestandteile.

Als Verbindungen oder Verbindungskombinationen, die unter Einwirkung von aktinischer Strahlung, insbesondere sichtbarem oder UV-Licht, die Polymerisation der Verbindung (2) einzuleiten vermögen, also vor allem Photoinitiatoren (3), kommen je nach gewünschtem Sensibilisierungsbereich unterschiedliche Materialien zum Einsatz. Soll das lichtempfindliche Material für den im Offsetdruck üblichen nahen UV-Bereich (350 - 420 nm) empfindlich sein, so werden andere Photoinitiator-Systeme verwendet, als wenn im sichtbaren Spektralbereich, beispielsweise mit Laserstrahlung, belichtet werden soll.

Die im nahen UV-Bereich zu belichtenden Photoinitiatoren sollen Licht im Bereich zwischen ca. 250 und 500 nm unter Ausbildung von Radikalen absorbieren. Beispiele sind Acyloine und deren Derivate wie Benzoin, Benzoinalkylether, vicinale Diketone und deren Derivate, z. B. Benzil, Benzilacetale wie Benzildimethylketal, Fluorenone, Thioxanthone, Mehrkernchinone, Acridine und Chinoxaline, ferner Trichlormethyl-s-triazine, 2-Halogenmethyl-4-vinyl-1,3,4-oxadiazolderivate, mit Trichlormethylgruppen substituierte Halogenoxazole, Trihalogenmethylgruppen enthaltende Carbonylmethylenheterocyclen und Acylphosphinoxid-Verbindungen. Die Photoinitiatoren lassen sich auch in Kombination miteinander oder mit Coinitiatoren bzw. Aktivatoren verwenden, z. B. mit Michlers Keton und seinen Derivaten oder 2-Alkyl-anthrachinonen. Bei den besonders für Laserbestrahlung im sichtbaren Bereich eingesetzten Photoinitiatoren kommen meist Gemische aus Metallocenen, photoreduzierbaren Farbstoffen, photolytisch spaltbaren Verbindungen mit Trihalogenmethylgruppen und ggf. weiteren Initiator- und Farbstoffbestandteilen in Frage, wie sie z. B. in der EP-A 364 735 beschrieben sind. Die Metallocen-Komponente besteht aus verschiedenartig substituierten Cyclopentadienyl-Komplexen des Titans oder Zirkoniums. Als photoreduzierbare Farbstoffe können Xanthen-, Benzoxanthen-, Benzothioxanthen-, Thiazin-, Pyronin-, Porphyrin- oder Acridin-Farbstoffe verwendet werden. Bei den Trihalogenmethyl-Coinitiatoren haben sich besonders die bekannten Triazin-Derivate mit Brom oder Chlor als Halogen bewährt. Weitere Initiatorbestandteile sind Verbindungen, die die Empfindlichkeit vor allem im nahen UV-Bereich steigern, z. B. Acridin-, Phenazin- oder Chinoxalin-Derivate, oder die eine Empfindlichkeitssteigerung im sichtbaren Bereich bewirken, z. B. Dibenzalacetone oder Cumarine.

Die Menge des Photoinitiators bzw. der Initiatorkombination beträgt im allgemeinen etwa 0,1 bis 15 Gew.-%, bevorzugt etwa 0,5 bis 10 Gew.-% der nichtflüchtigen Schichtbestandteile.

Die photopolymerisierbare Schicht kann darüber hinaus Stabilisatoren zur Unterdrückung von thermischer Polymerisation, Pigmente, Farbstoffe, Weichmacher oder andere Hilfsstoffe zur Verbesserung der mechanischen oder reprographischen Qualität enthalten. Dabei ist grundsätzlich zu beachten, daß die beigefügten Stoffe keinen übergroßen Anteil des für die Polymerisation notwendigen aktinischen Lichtes absorbieren und dadurch die praktische Lichtempfindlichkeit herabsetzen.

Die Schichtdicke der photopolymerisierbaren Schicht (c), ausgedrückt durch das Schichtgewicht, beträgt 0,1 bis 10, vorzugsweise 0,5 bis 5,0 g/m².

Als flexible transparente Deckfolien (d) für das erfindungsgemäße Material sind insbesondere solche Kunststoffolien geeignet, die beim Erwärmen auf etwa 60 bis 130 °C maßbeständig sind. Hierfür kommen z. B. Folien aus Celluloseacetat, Polyethylen, Polypropylen, Polystyrol, Polyamiden, Polycarbonaten, Polyestern und Polyimiden in Betracht. Die Folie sollte vorzugsweise für Luftsauerstoff wenig durchlässig sein. Deshalb werden vorzugsweise Folien aus Polyestern, Polycarbonaten, Polyimiden und ähnlichen Polymeren eingesetzt; Polyesterfolien werden im allgemeinen bevorzugt. Die Deckfolie kann eine Dicke im Bereich von etwa 5 bis 100, vorzugsweise 12 bis 50 µm aufweisen. Zur Verbesserung der Maßbeständigkeit werden die Folien im allgemeinen biaxial verstreckt und ggf. thermofixiert. Zur Verbesserung der Haftung der photopolymerisierbaren Schicht (c) kann die Oberfläche einer die Haftung erhöhenden Behandlung unterworfen werden, z. B. durch Coronaentladung, durch Ätzen mit Chemikalien, z. B. Trichloressigsäure, und durch Beschichten mit einer haftvermittelnden Unterschicht. Derartige Beschichtungen sind im allgemeinen 0,001 bis 0,1 µm dick. Sie können aus Copolymeren von (Meth)acrylsäureestern bestehen, wie sie z. B. in der US-A 4 098 952 beschrieben sind, und vorzugsweise vernetzt sein. Geeignete Folien sind in der US-A 5 049 476 beschrieben. Die Oberfläche der Folie kann auch einer das Blocken verhindernden Behandlung unterworfen werden, z. B. durch Beschichten mit einer geeigneten Schicht, die feinteilige organische oder insbesondere anorganische Partikel enthält, deren Größe, Menge und Brechungsindex so bemessen sind, daß die Transparenz der Folie nicht beeinträchtigt ist. Es soll verhindet werden, daß der aufgelegte Vorlagenfilm durch Adhäsionskräfte "blockt" und sich dadurch nur ruckartig in die richtige Position bringen läßt. Die Oberfläche kann glatt oder mattiert sein. Entsprechende Folien sind z. B. in der EP-A 130 222 beschrieben.

Der Schichtträger (a) ist eine als Trägermaterial für Flachdruckplatten übliche Aluminiumplatte mit hydrophiler Oberfläche. Das Aluminium kann im allgemeinen kleinere Mengen an Eisen, Silicium, Mangan, Zink, Titan, Kupfer u. dgl. als Legierungsbestandteile enthalten. Das Aluminium ist bevorzugt oberflächlich aufgerauht und anodisch oxydiert. Die Oberfläche kann weiterhin in bekannter Weise mit Alkalisilikaten, Phosphaten, Hexafluorozirkonaten, Polyvinylphosphonsäure oder anderen üblichen Vorbehandlungsmitteln behandelt worden sein. Die Dicke des Schichtträgers liegt im allgemeinen zwischen 0,05 und 1, vorzugsweise zwischen 0,1 und 0,5 mm.

Die Herstellung des lichtempfindlichen Materials erfolgt in der Weise, daß die Bestandteile der hydrophilen Schicht (b) in einem geeigneten Lösemittel, i. a. Wasser oder einem Gemisch von Wasser und damit mischbaren organischen Lösemitteln, wie niederen Alkanolen, Aceton oder dgl., gelöst und auf die Oberfläche des Schichtträgers (a) in der Weise aufgebracht werden, daß nach dem Trocknen die gewünschte Schichtdicke erhalten wird. Auf die getrocknete Zwischenschicht wird dann die photopolymerisierbare Schicht (c) in der Regel ebenfalls durch Beschichten aus einer Lösung aufgebracht. Das Lösemittel wird dabei so gewählt, daß die hydrophile Zwischenschicht (b) nicht angelöst wird. Auf die photopolymerisierbare Schicht (c) wird dann durch Laminieren die Deckfolie (d) aufgebracht. Das Laminieren kann bei Raumtemperatur oder bei erhöhter Temperatur erfolgen. Es kann auch die photopolymerisierbare Schicht durch Beschichten aus einer Lösung auf die Deckfolie aufgebracht, dort getrocknet und dann durch Laminieren auf den mit der hydrophilen Schicht (b) beschichteten Schichträger (a) aufgebracht werden. Dieser Laminiervorgang kann auch zu einem späteren Zeitpunkt nach Lagerung der Elemente aus (a) + (b) und (c) + (d) durchgeführt werden. In diesem Fall ist es aber zweckmäßig, die freiliegende Seite der photopolymerisierbaren Schicht (c) mit einer abtrennbaren Schutzfolie, z. B. aus Polyethylen, abzudecken, die dann erst unmittelbar vor dem Laminieren abgezogen wird.

Das erhaltene lichtempfindliche Material wird in bekannter Weise durch die transparente Deckfolie (d) hindurch bildmäßig belichtet. Die Belichtung kann durch eine entsprechend gesteuerte Strahlungsquelle, z. B. einen Laser, oder im Kontakt unter einer Transparentvorlage erfolgen. Durch die bildmäßige Vernetzung der photopolymerisierbaren Schicht (c) wird deren Haftung gegenüber der Deckfolie (d) und bzw. oder der hydrophilen Zwischenschicht (b) so verändert, daß beim Abziehen der Deckfolie nur die unbelichteten Schichtbereiche mit dieser entfernt werden. Dabei verbleibt ein negatives Bild auf dem Schichtträger (a). Da allgemein die Haftung der photopolymerisierbaren Schicht gegenüber der rauhen Oberfläche des Schichtträgers (a), die durch die relativ dünne hydrophile Schicht (b) nicht eingeebnet wird, stärker ist als gegenüber der transparenten Deckfolie (d), sollte diese Folie in der Regel eine haftverstärkende Oberflächenbehandlung erfahren, wie es oben beschrieben ist.

Nach der Bildentwicklung kann das auf dem Schichtträger verbliebene Bild zur Erhöhung der Auflagenstabilität beim Druck in an sich bekannter Weise thermisch oder durch Bestrahlen bzw. Belichten nachgehärtet werden.

Durch das erfindungsgemäße Material und Verfahren wird erreicht, daß man Flachdruckplatten durch eine Verarbeitung erhält, zu der keine flüssigen Entwickler oder andere Verarbeitungslösungen erforderlich sind. Gegenüber bekannten Verfahren dieser Art hat das erfindungsgemäße Verfahren den Vorteil, daß es Druckplatten mit einer deutlich höheren Auflagenstabilität liefert.

Die folgenden Beispiele erläutern bevorzugte Ausführungsformen der Erfindung. Mengenverhältnisse und Prozentangaben sind, wenn nichts anderes gesagt wird, als Gewichtseinheiten zu verstehen. Die Mengen werden zumeist in Gewichtsteilen (Gt) angegeben.

### Beispiel 1

a) Eine Lösung der im folgenden angegebenen Zusammensetzung wurde auf eine 50 µm dicke biaxial verstreckte und thermofixierte Polyethylenterephthalatfolie aufgebracht, deren Oberflächen auf beiden Seiten zur Haftverbesserung vorhandelt worden waren (®Melinex 505, ICI):
   2,36 Gt Polyethylmethacrylat (Tg 65 °C, Säurezahl 8, Viskosität 300 mPa·s in 37,5 %iger Lösung in Toluol bei 25 °C),
   0,05 " Polymethylmethacrylat (Tg 105 °C, Säurezahl <1),
   2,15 " Trimethylolpropantriacrylat,
   0,08 " 2-Benzyl-2-dimethylamino-1-(4-morpholino-phenyl)-butan-1-on,
   0,25 " Renolblau B2G (C. 1. 74 160),
   0,09 " 4-Diethylamino-4'-methoxy-dibenzalaceton und
   0,03 " 2,6-Di-tert.-butyl-4-methylphenol in
   49,8 " Butanon,
   2,5 " Tetrahydrofuran,
   35,6 " Propylenglykolmonomethylether und
   7,13 " γ-Butyrolacton
   Nach dem Trocknen betrug das Schichtgewicht 1,91 g/m².
b) Eine 0,3 mm dicke elektrolytisch aufgerauhte und anodisch oxydierte Aluminiumplatte mit einem Oxidschichtgewicht von 3,6 g/m² wurde mit einer 0,1 %igen wäßrigen Polyvinylphosphonsäurelösung nachbehandelt. Auf diesen Schichtträger wurde eine wäßrige Lösung von 0,7 % eines teilverseiften Polyethylenglykol/Vinylacetat-Pfropfpolymerisats mit der Esterzahl 150, 0,3 % Polyethylenglykol-(400)-dimethacrylat und 0,001 % Hydrochinonmonomethylether aufgeschleudert, so daß sich nach dem Trocknen ein Schichtgewicht von 0,1 g/m² ergab.
c) Das unter (a) beschriebene photopolymerisierbare Material wurde unter Druck bei 90 °C auf den unter (b) beschriebenen Schichtträger laminiert. Die erhaltene lichtempfindliche Druckplatte wurde mit einer 5 kW Metallhalogenidlampe im Abstand von 110 cm 12 Sekunden im Kontakt unter einer Testvorlage belichtet. Danach wurde die Polyesterfolie von Hand abgezogen, wobei die unbelichteten Schichtbereiche sauber mit der Folie entfernt wurden und die belichteten Schichtbereiche zusammen mit der gehärteten Polyvinylalkoholschicht auf der Aluminiumplatte als negative Kopie guter Auflösung zurückblieben. Das Negativbild wurde ohne Vorlage 100 Sekunden nachbelichtet und zur Prüfung der Resistenz gegen Auswaschen jeweils 20 Minuten im Ultraschallbad mit Wasser (1), mit 1%iger wäßriger Polyethylenglykol-(300)-nonylphenylether-Lösung (2) und mit 1 %iger Natrium-Dodecylbenzolsulfonatlösung (3) behandelt. In keinem Falle wurden dabei die Bildstellen angegriffen oder unterwaschen. Auf einer handelsüblichen Offsetdruckmaschine wurden in mehreren Versuchen 40.000 bis 50.000 Drucke gleichbleibender Qualität erreicht.

### Vergleichsbeispiel 1

Wie in Beispiel 1 wurde eine Aluminiumplatte mit einer 1 %igen Lösung des in Beispiel 1 angegebenen Pfropfpolymerisats in Wasser beschichtet. Nach dem Trocknen betrug das Schichtgewicht 0,1 g/m². Das gemäß Beispiel 1(a) hergestellte photopolymerisierbare Material wurde, wie unter 1(c) beschrieben, auf die beschichtete Aluminiumplatte laminiert, belichtet und durch Abziehen der Polyesterfolie entwickelt. Die erhaltene Druckplatte blieb bei der Ultraschallbehandlung in Wasser stabil, wurde aber in Lösung (2) wenig und in Lösung (3) etwas stärker unterspült, was sich durch Unterwaschen und Ablösen von einzelnen Bildelementen zu erkennen gab. Unter den gleichen Druckbedingungen wie in Beispiel 1 wurden nur 8.000 bis 10.000 Drucke gleichbleibender Qualität erhalten.

### Beispiel 2

Wie in Beispiel 1 beschrieben, wurde eine lichtempfindliche Druckplatte hergestellt und verarbeitet. Auf der Aluminiumplatte wurde jedoch in der Zwischenschicht das Polyethylenglykoldimethacrylat durch Triethylenglykoldimethacrylat ersetzt. Das Ergebnis der Resistenzprüfung ist in Tabelle 1 angegeben.

### Beispiel 3

Wie in Beispiel 1 beschrieben, wurde eine lichtempfindliche Druckplatte hergestellt und verarbeitet, wobei aber das Monomere in der Zwischenschicht durch Methacrylsäure ersetzt und dieser Beschichtungslösung zusätzlich 0,01 % p-Toluolsulfonsäure zugesetzt wurden. Das Ergebnis der Resistenzprüfung ist in Tabelle 1 angegeben.

### Vergleichsbeispiel 2

Eine lichtempfindliche Druckplatte wurde hergestellt und verarbeitet, wie in Beispiel 1 beschrieben. Dabei wurde die Aluminiumplatte mit einer 1 %igen Lösung eines zu 98,4 % hydrolysierten Polyvinylacetats mit dem K-Wert 4 so beschichtet, daß nach dem Trocknen ein Schichtgewicht von 0,1 g/m² erhalten wurde. Das Ergebnis der Resistenzprüfung ist in Tabelle 1 angegeben.

**Tabelle 1**

| **Beispiel** | **Lösung 1** | **Lösung 2** | **Lösung 3** |
|---|---|---|---|
| 2 | ++ | ++ | ++ |
| 3 | ++ | ++ | ++ |
| V2 | ++ + | - | - |
| -- = Bildelemente stark beschädigt - = " deutlich " 0 = " leicht " + = " geringfügig " ++ = " nicht " V = Vergleichsbeispiel | | | |

### Beispiele 4 - 10

Wie in Beispiel 1 beschrieben, wurden verschiedene lichtempfindliche Druckplatten hergestellt und verarbeitet. Die Zusammensetzung der lichtempfindlichen Schichten und ihre Schichtgewichte sind in Tabelle 2 angegeben.

Nach Belichtung und manuellem Abziehen der Polyesterfolie verblieben auf den Aluminiumplatten saubere Negativbilder guter Auflösung, die gegenüber der Einwirkung eines Gemischs aus Druckfarbe und Feuchtmittel stabil sind.

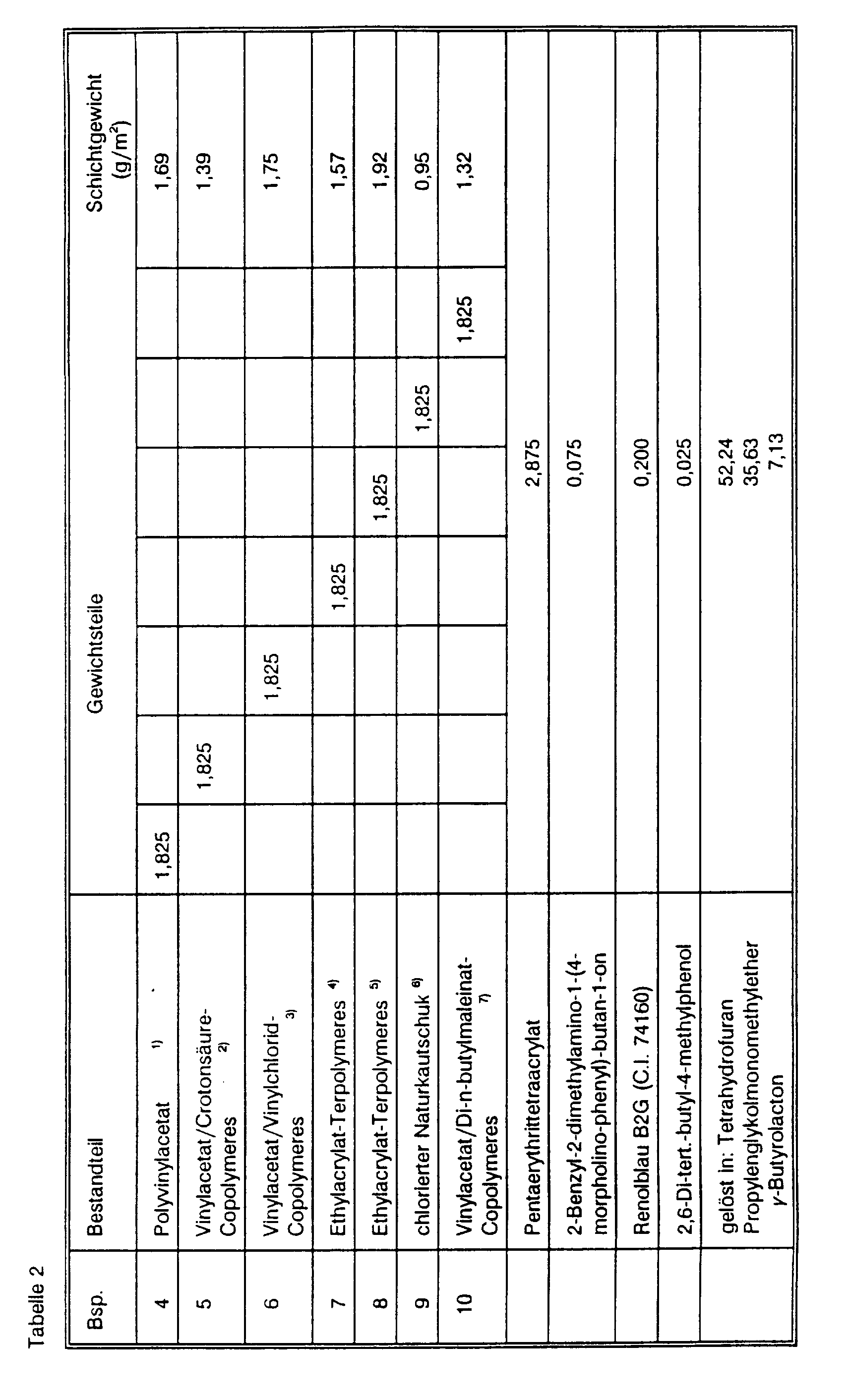

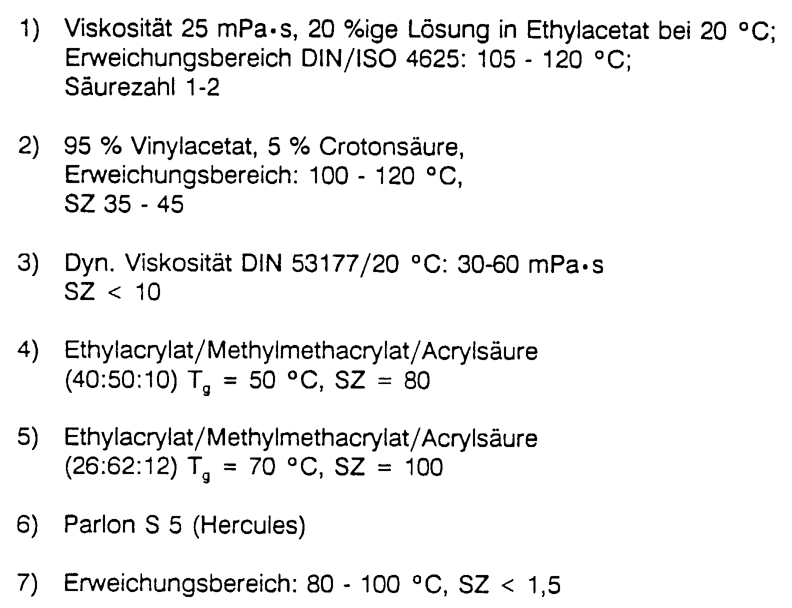

### Beispiele 11-15

Analog Beispiel 1 wurden verschiedene lichtempfindliche Druckplatten hergestellt und verarbeitet, wobei jedoch in der hydrophilen, radikalisch polymerisierbaren Schicht das teilverseifte Polyethylenglykol/Vinylacetat-Pfropfpolymerisat durch eines bzw. ein Gemisch der Polymeren A bis F ersetzt wurde. Die Polymeren und die Schichtgewichte der hydrophilen Schichten sind in Tabelle 3 angegeben.

Nach Belichten und manuellem Abziehen der Polyesterfolie verblieben auf der Aluminiumplatte scharfe Negativbilder guter Auflösung, die gegenüber einem Feuchtmittel/Druckfarbe-Gemisch absolut wischfest sind und ohne Hintergrundton angefärbt werden.

**Tabelle 3**

| Beispiel | Polymeres | Schichtgewicht |
|---|---|---|
| 11 | A N-Vinyl-N-methyl-acetamid/Bis(2-ethyl-hexyl)maleinat-Copolymeres | 0,32 |
| | | |
| 12 | B Polyvinylpyrrolidon; K-Wert 90 - 103 | 0,19 |
| | | |
| 13 | C+D 1:1 | 0,16 |
| | C: Polyvinylpyrrolidon; K-Wert 11-14; eingesetzt als 50%ige Lösung in H₂O | |
| | D: Polyethylenoxid (M_{w} = 400.000) | |
| | | |
| 14 | C + E 3:7 | 0,18 |
| | E: Polyethylenoxid (M_{w} = 300.000) | |
| | | |
| 15 | F Polyethylenimin (50 %ige wäßrige Lösung) (Viskosität 17.000 - 28.000 mPa·s bei 20 °C) | 0,15 |

### Beispiel 16

Wie in Beispiel 1 beschrieben, wurde eine lichtempfindliche Druckplatte durch Beschichten mit der folgenden Lösung hergestellt:

| | |
|---|---|
| 2,98 Gt | Polyethylmethacrylat wie in Beispiel 1, |
| 0,746 Gt | Polyethylmethacrylat (Tg = 63 °C, SZ = 0; Viskosität 7500 mPa·s in 37,5 %iger Lösung in Toluol bei 25 °C), |
| 0,14 Gt | Polymethylmethacrylat wie in Beispiel 1, |
| 2,46 Gt | Pentaerythrittetraacrylat, |
| 0,203 Gt | Bis-cyclopentadienyl-bis-[2,6-difluor-3-(pyrr-1-yl)phenyl]-titan, |
| 0,035 Gt | 2,6-Di-tert.-butyl-4-methylphenol, |
| 0,175 Gt | Renolblau B2G (C.I. 74160), |
| 0,028 Gt | 2-(p-Styryl-phenyl)-4,6-bis-trichlormethyl-s-triazin und |
| 0,322 Gt | Eosin alkohollöslich (C.I. 45386) in |
| 51,2 Gt | Butanon, |
| 34,9 Gt | Propylenglykolmonomethylether und |
| 6,98 Gt | γ-Butyrolacton |

Das Schichtgewicht nach dem Trocknen betrugt 1,71 g/m². Die entsprechend Beispiel 1 hergestellte Druckplatte lieferte nach 5 s Belichtung mit einer 500 W Glühlampe (Abstand 110 cm) und manuellem Abziehen eine scharfe, negative Druckform, die gegenüber der mechanischen Einwirkung eines Gemischs aus Druckfarbe und Feuchtmittel absolut wischfest ist und von diesem korrekt angefärbt wurde.

### Beispiel 17

Analog zu Beispiel 1 wurde eine lichtempfindliche Druckplatte durch Beschichten mit der folgenden Lösung hergestellt:

| | |
|---|---|
| 84,0 Gt | Polyethylmethacrylat wie in Beispiel 1 |
| 96,0 Gt | Pentaerythrit-tetraethoxy-tetraacrylat |
| 3,00 Gt | 2-Benzyl-2-dimethylamino-1-(4-morpholino-phenyl)-butan-1-on |
| 15,0 Gt | Hostapermblau B2G (C.I. 74160) |
| 1,00 Gt | 2,6-Di-tert.-butyl-4-methylphenol und |
| 1,00 Gt | Silikonöl (Edaplan LA 411) in |
| 990 Gt | Butanon |
| 675 Gt | Propylenglykolmonomethylether |
| 135 Gt | γ-Butyrolacton |

Nach dem Trocknen resultierte ein Schichtgewicht von 1,32 g/m².

Mit 80,0 Gt des Polyethylenglykol/Vinylacetat-Pfropfpolymerisats gemäß Beispiel 1, 20,0 Gt Hydroxyethylmethacrylat, 240 Gt Wasser und 160 Gt Propylenglykolmonomethylether wurde eine Stammlösung hergestellt. Die Stammlösung wurde anschließend mit einem Lösemittelgemisch aus Wasser und Propylenglykolmonomethylether (Verhältnis 3:2) auf die folgenden Gehalte an nichtflüchtigen Bestandteilen verdünnt

| | |
|---|---|
| a) | Stammlösung (20 %) |
| b) | 15% |
| c) | 10% |
| d) | 5% |
| e) | 3% |
| f) | 2% |
| g) | 1% |

und jeweils auf eine Al-Platte aufgebracht. Die nach dem Trocknen bei 100 °C erhaltenen Schichtgewichte sind in Tabelle 4 zusammengestellt.

Wie unter Beispiel 1 beschrieben, wurden die Druckplatten belichtet und durch Abziehen der Polyesterfolie von Hand entwickelt. Die in Abhängigkeit von der Dicke der hydrophilen Schicht erhaltene Bildqualität ist zusammen mit der Wischfestigkeit gegenüber einer Feuchtmittel/Druckfarben-Mischung und den Ergebnissen eines Unterspülungstests bei 20 min. Ultraschallbehandlung in Wasser in Tab. 4 angegeben.

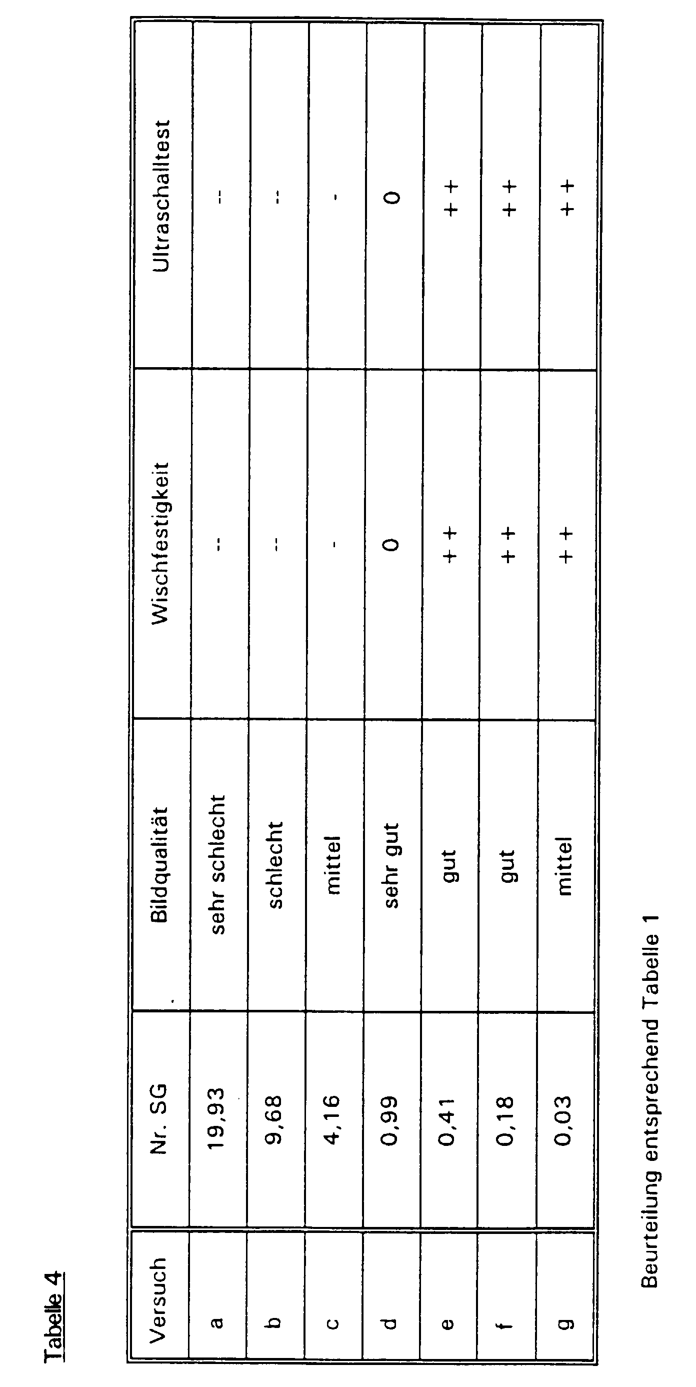

## Patentansprüche

1. Lichtempfindliches Material für die Herstellung von Flachdruckplatten, das als wesentliche Bestandteile
a) einen Schichtträger,
b) eine hydrophile Schicht, die ein organisches Polymeres und eine radikalisch polymerisierbare Verbindung enthält,
c) eine photopolymerisierbare Schicht, die
(1) ein polymeres Bindemittel,
(2) eine radikalisch polymerisierbare Verbindung und
(3) eine Verbindung oder eine Verbindungskombination enthält, die unter Einwirkung von aktinischer Strahlung die Polymerisation der Verbindung (2) einzuleiten vermag, und
d) eine transparente Deckfolie
enthält, wobei die Haftung der photopolymerisierbaren Schicht (c) an der hydrophilen Schicht (b) und/oder der Deckfolie (d) durch Belichten verändert wird, dadurch gekennzeichnet, daß der Schichtträger (a) aus Aluminium bzw. einer Aluminiumlegierung besteht und für den Flachdruck geeignet ist und daß die hydrophile Schicht (b) ein Schichtgewicht im Bereich von 0,001 bis 1 g/m² hat und keinen Photoinitiator umfaßt.

2. Lichtempfindliches Material nach Anspruch 1, dadurch gekennzeichnet, daß die photopolymerisierbare Schicht (c) ein Schichtgewicht im Bereich von 0,1 bis 10 g/m² aufweist.

3. Lichtempfindliches Material nach Anspruch 1, dadurch gekennzeichnet, daß das polymere Bindemittel (1) in der Schicht (c) oleophil ist.

4. Lichtempfindliches Material nach Anspruch 1, dadurch gekennzeichnet, daß die radikalisch polymerisierbare Verbindung (2) in der Schicht (c) mindestens zwei ethylenisch ungesättigte polymerisierbare Gruppen enthält.

5. Lichtempfindliches Material nach Anspruch 1, dadurch gekennzeichnet, daß die photopolymerisierbare Schicht (c) 10 bis 90 Gew.-% Bindemittel (1), 5 bis 80 Gew.-% polymerisierbare Verbindung (2) und 0,1 bis 15 Gew.-% durch Strahlung aktivierbaren Polymerisationsinitiator (3), bezogen auf die Menge der nichtflüchtigen Bestandteile der Schicht, enthält.

6. Lichtempfindliches Material nach Anspruch 1, dadurch gekennzeichnet, daß der Schichtträger (a) an seiner Oberfläche mechanisch, chemisch oder elektrolytisch aufgerauht und anodisch oxydiert ist.

7. Verfahren zur Herstellung einer Flachdruckform, bei dem man ein lichtempfindliches Material der in Anspruch 1 angegebenen Beschaffenheit bildmäßig durch die Deckfolie (d) belichtet und durch Abziehen der Deckfolie von dem Schichtträger (a) entwickelt.

8. Verfahren nach Anspruch 7, dadurch gekennzeichnet, daß man die erhaltene Flachdruckform nach dem Entwickeln durch Erwärmen oder Bestrahlen nachhärtet.

## Claims

1. Photosensitive material for the production of planographic printing plates which contains as essential constituents
a) a layer support,
b) a hydrophilic layer, which contains an organic polymer and a free-radically polymerisable compound,
c) a photopolymerisable layer which contains
(1) a polymeric binder,
(2) a free-radically polymerisable compound and
(3) a compound or combination of compounds capable of initiating polymerisation of compound (2) under the action of actinic radiation, and
d) a transparent cover film,
wherein the adhesion of the photopolymerisable layer (c) to the hydrophilic layer (b) and/or the cover film (d) is modified by exposure to light, characterised in that the layer support (a) consists of aluminium or an aluminium alloy and is suitable for planographic printing and that the hydrophilic layer (b) has a layer weight in the range from 0.001 to 1 g/m² and does not comprise a photoinitiator.

2. Photosensitive material according to claim 1, characterised in that the photopolymerisable layer (c) has a layer weight in the range from 0.1 to 10 g/m².

3. Photosensitive material according to claim 1, characterised in that the polymeric binder (1) in layer (c) is oleophilic.

4. Photosensitive material according to claim 1, characterised in that the free-radically polymerisable compound (2) in layer (c) contains at least two ethylenically unsaturated polymerisable groups.

5. Photosensitive material according to claim 1, characterised in that the photopolymerisable layer (c) contains 10 to 90 wt.% of binder (1), 5 to 80 wt.% of polymerisable compound (2) and 0.1 to 15 wt.% of radiation-activatable polymerisation initiator (3), relative to the quantity of non-volatile constituents in the layer.

6. Photosensitive material according to claim 1, characterised in that the surface of the layer support (a) is mechanically, chemically or electrolytically roughened and anodically oxidised.

7. Process for the production of a planographic printing member, in which a photosensitive material of the type stated in claim 1 is exposed with an image through the cover film (d) and is developed by peeling the cover film from the layer support (a).

8. Process according to claim 7, characterised in that, once developed, the resultant planographic printing member is post-cured by heating or irradiation.

## Revendications

1. Matériau photosensible pour la fabrication de plaques d'impression lithographique, qui contient comme constituants principaux
a) un support de couche,
b) une couche hydrophile qui contient un polymère organique et un composé polymérisable radicalairement,
c) une couche photopolymérisable, qui contient
(4) un liant polymère,
(5) un composé polymérisable radicalairement et
(6) un composé ou une combinaison de composés, qui est susceptible de provoquer la polymérisation du composé (2) par action d'un rayonnement actinique, et
d) une couche de couverture transparente,
l'adhérence de la couche photopolymérisable (c) sur la couche hydrophile (b) et/ou la couche de couverture (d) étant modifiée par irradiation, caractérisé en ce que le support de couche (a) est constitué d'aluminium, respectivement d'un alliage d'aluminium, et convient pour l'impression lithographique et en ce que la couche hydrophile (b) a un poids de couche dans la plage de 0,001 à 1 g/m² et ne comporte pas de photoinitiateur.

2. Matériau photosensible selon la revendication 1, caractérisé en ce que la couche photopolymérisable (c) présente un poids de couche dans la plage de 0,1 à 10 g/m².

3. Matériau photosensible selon la revendication 1, caractérisé en ce que le liant polymère (1) dans la couche (c) est lipophile.

4. Matériau photosensible selon la revendication 1, caractérisé en ce que le composé polymérisable radicalairement (2) dans la couche (c)contient au moins deux groupes polymérisables insaturés éthyléniquement.

5. Matériau photosensible selon la revendication 1, caractérisé en ce que la couche photopolymérisable (c) contient 10 à 90% en poids du liant (1), 5 à 80% en poids du composé polymérisable (2) et 0,1 à 15% en poids de l'initiateur de polymérisation activable par rayonnement (3), rapporté à la quantité de constituants non volatils de la couche.

6. Matériau photosensible selon la revendication 1, caractérisé en ce que le support de couche (a) est rendu rugueux mécaniquement, chimiquement ou électrolytiquement sur sa surface et oxydé anodiquement.

7. Procédé de préparation d'une forme d'impression lithographique selon lequel on développe pour former une image un matériau photosensible ayant la caractéristique donnée dans la revendication 1 par irradiation de la couche de couverture (d) et par pelage de la couche de couverture du support de couche (a).

8. Procédé selon la revendication 7, caractérisé en ce qu'on durcit postérieurement la forme d'impression lithographique obtenue après le développement par chauffage ou irradiation.
